# EUROPEAN PATENT APPLICATION

(11) **EP 4 797 262 A1**
(43) Date of publication of application: **26.08.2026**
(21) Application number: 26155645.0
(22) Date of filing: 02.02.2026
(51) Int. Cl.: G11C 5/06, H10W 72/00, B23K 20/00

(54) **AUTOMATIC WIRE THREADING METHOD AND SYSTEM**

(30) Priority: 25.02.2025 US 202519062428
(71) Applicant: ASMPT Singapore Pte. Ltd., Singapore 768924 (SG)
(72) Inventor: ZHANG, Yue, 768924 Singapore (SG)
(74) Representative: Emerson, Peter James

(57) **Abstract**

A wire threading method for automatically threading a bonding wire in a wire bonding apparatus includes the following steps: feeding a length of the bonding wire from a wire spool into an air path device; tensioning the bonding wire with an airflow generated in the air path device and simultaneously guiding a wire tail of the bonding wire to an operation location with the air path device; gripping and straightening the wire tail at the operation location with a wire manipulating device; conveying the straightened wire tail to a threading location with the wire manipulating device; and threading the straightened wire tail with a wire threading device through a bonding tool of the wire bonding apparatus.

## Description

### Field of the Invention

The invention generally relates to a wire bonding apparatus, and in particular to an automatic wire threading method and system for a wire bonding apparatus.

### Background

Wire bonding is a key process in semiconductor packaging for establishing electrical connections between an integrated circuit (IC) chip and its package via conductive bonding wires, typically made of gold, aluminum, or copper. In ultrasonic wire bonding, a bonding wire fed from a spool is threaded into the capillary of an ultrasonic transducer, where ultrasonic energy and force are applied at the capillary tip to weld the bonding wire to a bonding pad.

The wire threading process must be performed each time the spool of bonding wire is replaced or whenever the bonding wire escapes from the capillary. During this process, the bonding wire needs to be re-threaded from the spool, through intermediate equipment, and into the capillary. The existing wire threading process requires substantial manual efforts and a skilled operator, as it involves the delicate handling of the bonding wires. Although some automatic wire threading methods have been proposed in prior art, they often present limitations in terms of reliability or complexity.

It would therefore be beneficial to provide an improved automatic wire threading method for a wire bonding apparatus.

### Summary of the Invention

It is thus an object of the invention to seek to provide an automatic wire threading method and system to minimize manual intervention while enhancing the efficiency and reliability of the wire threading process.

According to a first aspect of the present invention, there is provided a wire threading method for automatically threading wire in a wire bonding apparatus. The method includes the steps of: feeding a length of a bonding wire from a wire spool into an air path device; tensioning the bonding wire with an airflow generated in the air path device and simultaneously guiding a wire tail of the bonding wire to an operation location; gripping and straightening the wire tail at the operation location with a wire manipulating device; conveying the straightened wire tail to a threading location with the wire manipulating device and threading the straightened wire tail with a wire threading device through a bonding tool of the wire bonding apparatus.

By employing the wire guide device to automatically direct the wire tail of the bonding wire to the operation location beneath the air path device, followed by straightening the wire tail at the operation location using a wire manipulation device, and then conveying the straightened tail to the threading location, a more efficient and reliable automatic wire threading process in the wire bonding apparatus can be achieved compared to prior art wire threading method.

In some embodiments, the length of the bonding wire may be automatically fed or sent into the air path device with a robotic arm or a movable wire feeding mechanism.

In some embodiments, the step of guiding the wire tail may include guiding the wire tail to the operation location with the wire guide device movably between a first position remote from the operation location and a second position adjacent to the operation position, wherein the wire tail is guided to the operation location as the wire guide device moves from the first position to the second position.

In some embodiments, the wire guide element coupled to the air path device. The guide element may be in the form of a pivotable guide rod/finger that can rotate around a pivot. The guide element has two opposite ends: the first end is rotatably coupled to a pivot installed on the air path device, while the second end is a free end that can move between the first position, remote from the operation location, and the second position, adjacent to the operation location with the rotation of the first end.

In some embodiments, the air path device includes an airflow generator for generating the airflow for tensioning the bonding wire and a wire stopper configured to confine the bonding wire within the air path device or to prevent the bonding wire from flying out from the air path device. The wire stopper may include a mesh structure or one or more individual block-like structures or components.

In some embodiments, the method may further include a step of removing a part of the wire tail from the bonding wire to form a straight and hard wire tip portion before conveying the straightened wire tail to the threading location for threading. This can facilitate the subsequent wire threading process. In some embodiments, the removal step may be performed simultaneously as the wire manipulating device straightens the wire tail.

In some embodiments, the method may further include a step of forming a weakened portion on the wire tail with the wire manipulating device before removing the part of the wire tail. This can reduce the force required for removal of the part of the wire tail to form the wire tip portion. This reduces the force needed to remove the part of the wire tail, thereby facilitating the formation of the straight and hard wire tip portion.

In some embodiments, the wire manipulating device includes first and second movable wire manipulators, the step of gripping the wire tail includes: gripping a first part of the wire tail with the first wire manipulator at a first position at the operation location and gripping a second part of the wire tail with the second wire manipulator at a second position at the operation location, wherein the first position is closer to the air path device than the second position, and the second part is closer to a free end of the wire tail than the first part.

In some embodiments, before the wire manipulating device straightens the wire tail gripped by the first and second wire manipulators, the first and second wire manipulators may restrain the wire tail solely by an airflow generated within them. This allows the free end of the bonding wire to be adjusted and positioned at a predetermined position relative to the second wire manipulator by activating the wire spool, such as by rewinding the wire spool.

In some embodiments, the step of forming the weakened portion on the wire tail includes forming the weakened portion on the second part of the wire tail with the second wire manipulator. The second wire manipulator may incorporate a cutting mechanism configured to apply force to a specific point on the second part of the wire tail to form the weakened portion while the second part of the wire tail is gripped by the second wire manipulator.

In some embodiments, the step of straightening the wire tail may include moving the first wire manipulator away from the second wire manipulator to straighten the wire tail and break the wire tail at the weakened portion simultaneously so that a part of the wire tail is removed from the bonding wire and gripped by the second wire manipulator.

This arrangement simplifies the motions of the wire-manipulating device, enhancing both the efficiency and accuracy of the wire threading process.

In some embodiments, the method may further include a step of automatically transferring the part of the wire tail removed from the bonding wire to a container with a vacuum suction mechanism, wherein the vacuum mechanism includes a suction nozzle coupled to the second wire manipulator for receiving the removed part of the wire tail and a pipe connecting the suction nozzle to the container for transferring the removed part of the wire tail into the container. This can efficiently collect the removed bonding wires without requiring any human intervention.

According to a second aspect of the present invention, there is provided a wire threading system for automatically threading a bonding wire in a wire bonding apparatus. The wire threading system includes a wire feeding device, an air path device, a wire guide device, a wire manipulating device and a wire threading device. The wire feeding device is configured to feed a length of the bonding wire from a wire spool into the air path device. The air path device is configured to tension the bonding wire using an airflow. The wire guide device is configured to guide a wire tail of the bonding wire to an operation position when the bonding wire is tensioned by the air path device. The wire manipulating device is configured to grip and straighten the wire tail at the operation location, and convey the straightened wire tail to a threading location; and the wire threading device configured to receive the straightened wire tail and to thread the straightened wire tail though a bonding tool of the wire bonding apparatus.

These and other features, aspects, and advantages will be better understood with regard to the description section, appended claims, and accompanying drawings.

### Brief Description of the Drawings

Embodiments of the present invention will now be described, by way of example only, with reference to the accompanying drawings, in which:
FIG. 1 illustrates schematically the major components of a wire threading system for automatically threading a wire bonding apparatus according to some embodiments of the invention;
FIG. 2 shows a perspective view of an air path device of the wire threading system shown in FIG. 1, according to one embodiment of the invention;
FIG. 3A shows a perspective view of a first wire manipulator of a wire manipulating device of the wire threading system shown in FIG. 1, according to one embodiment of the invention; FIG.3B and FIG. 3C respectively show perspective and sectional views of the first wire manipulating assembly;
FIG. 4A shows a perspective view of a second wire manipulator of the wire manipulating device of the wire threading system shown in FIG. 1, according to one embodiment of the invention; FIG.4B and FIG. 4C respectively show perspective and sectional views of the second wire manipulating assembly; FIG. 4D shows a perspective view of a vacuum suction mechanism coupled to the second wire manipulator to receive a part of the wire tail removed from the bonding wire according to one embodiment of the invention;
FIG. 5A to FIG. 5I illustrate the main steps performed by the wire threading system shown in FIG. 1 when threading a bonding wire though the wire bonding apparatus according to some embodiments of the invention.

In the drawings, like parts are denoted by like reference numerals.

### Detailed Description of the Preferred Embodiments of the Invention

Before discussing embodiments of the invention in any more detail, first an overview will be provided. To improve the reliability and efficiency of a wire threading process for a wire bonding apparatus, some embodiments of the invention provide an automatic wire threading method and system. In the automatic wire threading method, a length of a bonding wire from a wire spool is fed into an air path device, where the bonding wire is tensioned by an airflow. Simultaneously, a wire tail or wire tail section of the bonding wire is guided to an operation location beneath the air path device by a wire guide device. At the operation location, the wire tail is gripped and straightened by a wire manipulating device before it is conveyed to a threading location for a subsequent wire threading process. The wire threading method and system will be described in greater detail below according to some embodiments of the invention.

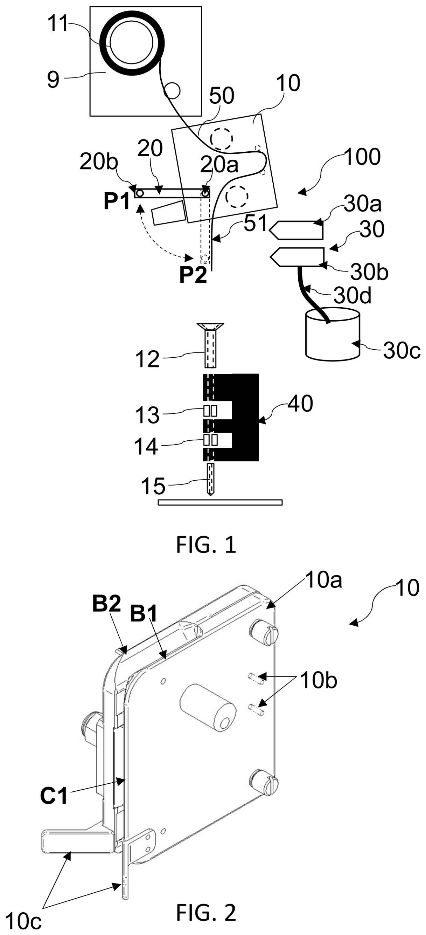

FIG. 1 illustrates schematically the major components of a wire threading system 100 for automatically threading a wire bonding apparatus according to some embodiments of the invention. Referring to FIG. 1, the wire bonding apparatus includes a wire spool 11, an air tensioner 12, a first wire clamp 13, a second wire clamp 14, a bonding tool 15 in the form of a capillary, and the wire threading system 100. The wire threading system 100 is configured to automatically thread a bonding wire 50 from the wire spool 11 through the air tensioner 12, the first wire clamp 13, the second wire clamp 14 and the capillary 15. The wire threading system 100 includes an air path device 10, a wire feeding device, a wire guide device 20, a wire manipulating device 30 and a wire threading device 40.

The air path device 10 is configured to receive a length of a bonding wire 50 from the wire spool 11 and tension the bonding wire 50 with an airflow generated therein. The length of the bonding wire 50 is fed or sent into the air path device 10 by the wire feeding device (not shown). The wire feeding device may include a robotic arm or other types of wire feeding mechanism.

The wire guide device 20 is configured to guide a wire tail section or wire tail 51 of the bonding wire 50 to an operation location beneath the air path device 10 as the bonding wire 50 is tensioned by the air path device 10. The wire guide device 20 may be in the form of a pivotable guide element movably coupled to the air path device 10. As shown in FIG. 1, the wire guide device 20 has a first end 20a and a second end 20b. The first end 20a is rotatably coupled to a pivot installed on the air path device 10, and the second end 20b is a free end that is movable between a first position P1 remote from the operation location and a second position P2 adjacent to the operation location. The wire guide device 20 is designed to operate in conjunction with the air path device 10 to guide the wire tail 51 to the predetermined operation location.

The wire manipulating device 30 is configured to move to the operation location and grip and straighten the wire tail 51 at the operation location and convey the straightened wire tail 51 to the threading location immediately above the air tensioner 12 of the wire bonding apparatus.

In these embodiments, the wire manipulating device 30 may be further configured to form a weakened portion on the wire tail 51 and remove a part of the wire tail 51 from the weakened portion to form a straight and hard wire tip portion before conveying the straightened wire tail 51 to the threading location for threading.

Referring to FIG. 1, the wire manipulating device 30 may include two movable wire manipulators, i.e., first wire manipulator 30a and second wire manipulator 30b. The first wire manipulator 30a is configured to move to a first position at the operation location proximate the air path device 10 and grip a first part of the wire tail 51 at the first position, while the second wire manipulator 30b is configured to move to a second position at the operation location remote from the air path device 10 so as to and grip a second part of the wire tail 51 at the second position. The second part of the wire tail 51 gripped by the second wire manipulator 30b is closer to the free end of the bonding wire 50 as compared to the first part. The first wire manipulator 30a is further configured to move upward, in a direction away from the second wire manipulator 30b, to straighten a part of the wire tail 51 between the first and second wire manipulators 30a and 30b. The second wire manipulator 30b may be further configured to form a weakened portion on the wire tail 51 and remove a part or segment of the wire tail 51 from the weakened portion to the free end of the bonding wire 50 as the first wire manipulator 30a moves to straighten the wire tail 51. This removal step is carried out to form the wire tip portion which is suitable for the subsequent threading process.

To automatically receive the part of the wire tail 51 removed from the bonding wire 50, the wire manipulating device 30 may further include a vacuum suction mechanism configured to automatically urge the removed wire towards a container 30c. The vacuum suction mechanism includes a suction nozzle coupled to the second wire manipulator 30b and a pipe 30d connecting the suction nozzle to the container 30c.

**In** these embodiments, the wire threading device 40 may be in the form of a movable E-block positioned below the air tensioner 12 of the wire bonding apparatus. The E-block is configured to receive the straightened wire tail 51 through the air tensioner 12 and to thread the straightened wire tail 51 through the bonding tool 15 via the first wire clamp 13 and second wire clamp 14. The structure and functions of the E-block will not be described in detail hereunder. The wire threading device 40 may take the form of any type of E-block or other types of wire threading devices suitable for the wire threading process.

FIG. 2 shows a perspective view of the air path device 10 according to one embodiment of the invention. Referring to FIG. 2, the air path device 10 includes a main body 10a and an airflow generator (not shown) for generating the airflow to tension the bonding wire 50 in the air path device 10. The main body 10a may include a pair of wire path plates, B1 and B2, which are coupled together to each other with a space present between them, allowing the airflow to direct the bonding wire 50 into the space. Each wire path plate may be in the form of a flat rectangular panel. The main body 10a has an inlet channel C1 for allowing the bonding wire 51 to enter into the air path device 10. The air path device 10 further includes a wire stopper 10b configured to confine the length of the bonding wire 50 within the air path device 10, i.e., to prevent the bonding wire 50 from flying out of the air path device 10 as the bonding wire 50 is tensioned by the airflow. The wire stopper 10b may be positioned on at least one of the wire path plates, near an opening opposite the inlet channel C1. The wire stopper 10b shown in FIG. 2 includes two individual stop bars, which are provided for illustrative purposes only and are not intended to limit the scope of the invention. It may have any structure and include various components as long as it fulfills the purpose of confining the bonding wire 50 within the air path device 10 during operation. In one example, the wire stopper 10b may have a mesh structure.

Referring to FIG. 2, the air path device 10 may further include a wire inlet guide 10c positioned near the inlet channel C1. The wire inlet guide 10c is configured to limit the movement of the bonding wire 50, thereby facilitating the delivery of the bonding wire 50 into the space formed between the wire path plates, B1 and B2 via the airflow.

The wire inlet guide 10c may include two guide elements, which are respectively attached to the pair of wire path plates, B1 and B2. The two guide elements form a narrowing opening relative to the inlet channel C1, to receive and direct the bonding wire 50. Each guide element may be in the form of an angled, elongated structure with one end firmly attached to its respective wire path plate. In other words, the two guide elements are arranged to guide the bonding wire 50 smoothly into the space between the two wire path plates B1 and B2 through the inlet channel C1.

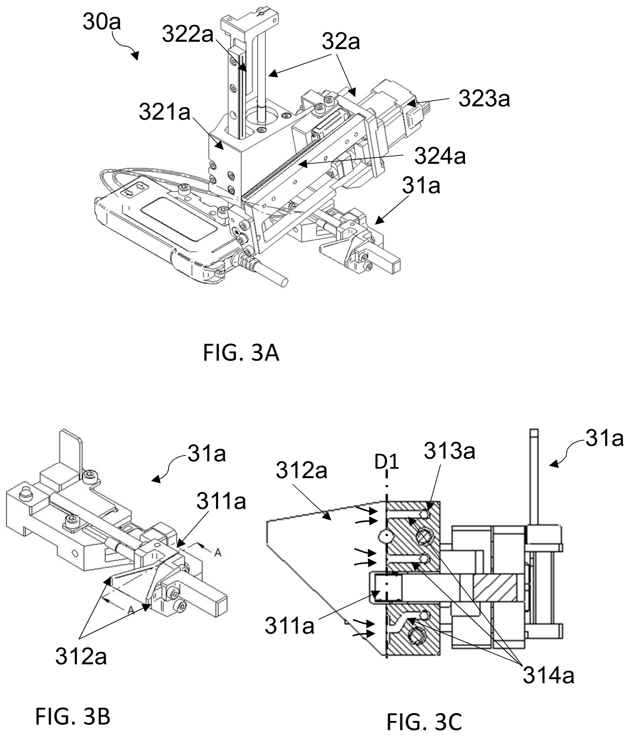

FIG. 3A shows a perspective view of a first wire manipulator 30a according to one embodiment of the invention. The first wire manipulator 30a is configured to search for the wire tail 51 at the operation location, grip and straighten the wire tail 51 and to transport the wire tail 51 to the threading location for the subsequent threading process. It includes a first wire manipulating assembly 31a configured to releasably grip the first part of the wire tail 51 and a first actuator assembly 32a configured to move the first wire manipulating assembly 31a to search, straighten and transport the wire tail 51 during the wire threading process.

Specifically, the first actuator assembly 32a is coupled to the first wire manipulating assembly 31a and is configured to move the first wire manipulating assembly 31a from its standby position to the first position, enabling it to releasably grip the first part of the wire tail 51 after the wire tail 51 has been positioned at the operation location. The first actuator assembly 32a also moves the first wire manipulating assembly 31a relative to the second wire manipulator 30b to straighten the part of the wire tail 51 between the first and second wire manipulators 30a and 30b. Additionally, the first actuator 32a is further configured to transport the straightened wire tail 51 to the threading position for the subsequent threading process.

Referring to FIG. 3A, the first actuator assembly 32a may include a first actuator 321a configured to move the first wire manipulating assembly 31a along a first motion rail 322a and a second actuator 323a configured to move the first wire manipulating assembly 31a along a second motion rail 324a. The first motion rail 322a may be aligned with the wire threading direction, such as the Z-axis or vertical direction, while the second motion rail 324a may be positioned at an acute angle relative to the wire threading direction. The ability to move in two directions (both vertical and angular directions) enables the first wire manipulating assembly 31a to position the bonding wire 50 more accurately at predetermined locations or in confined spaces, which helps to improve the overall performance of the bonding process.

FIG.3B and FIG. 3C respectively show perspective and sectional views of the first wire manipulating assembly 31a according to one embodiment of the invention. Referring to FIG. 3B and 3C, the first wire manipulating assembly 31a includes a first manipulating mechanism 311a configured to releasably grip the first part of the wire tail 51. The first manipulating mechanism 311a may include two clamping elements and a motor configured to move at least one of the two clamping elements to releasably grip the first part of the wire tail 51.

The first wire manipulating assembly 31a may also include a first entry guide 312a, which is attached to or extends from the first manipulating mechanism 311a, to guide the wire tail 51 into position for restraining and gripping by the first manipulating mechanism 311a. Specifically, the first entry guide 312a may include two guide elements, respectively attached to or extending from the two clamping elements of the first manipulating mechanism, forming a funnel-like space to facilitate the entry of the bonding wire 50.

The first wire manipulating assembly 31a may further include a first pneumatic restraining mechanism 313a configured to generate airflow to restrain the first part of the wire tail 51. This first pneumatic restraining mechanism 313a includes a plurality of first airflow channels or vacuum slots 314a connected to an airflow generator (not shown). Additionally, the first pneumatic restraining mechanism 313a is further configured to adjust the position of the first part of the wire tail 51 using an airflow so as to align it with a datum line D1.

The first wire manipulating assembly 31a may be further configured to restrain the wire tail 51 solely through the airflow generated by the first pneumatic restraining mechanism 313a. This configuration allows for precise adjustment of the length of the bonding wire 50 to position the free end of the bonding wire 50 at a predetermined position by activating the wire spool 11.

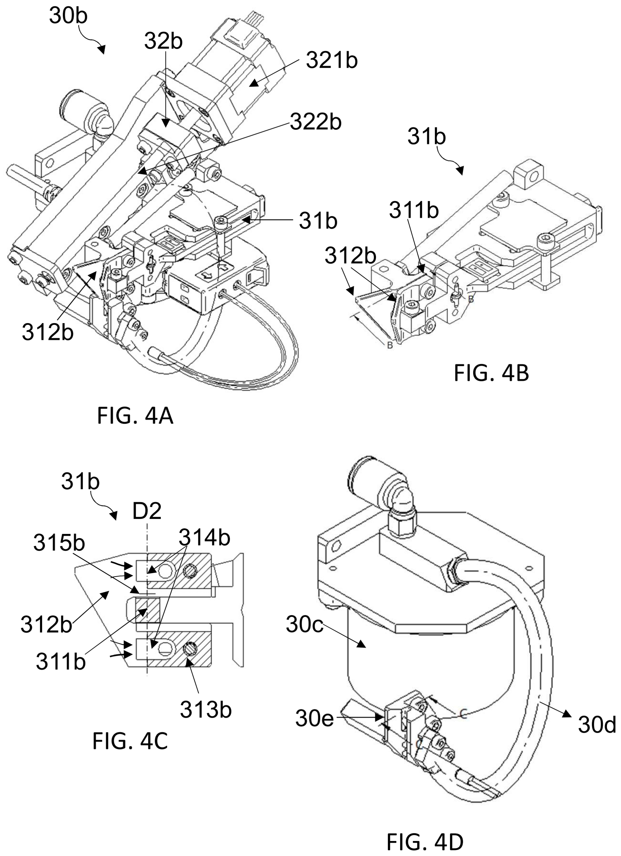

FIG. 4A shows a perspective view of the second wire manipulator 30b according to one embodiment of the invention. The second wire manipulator 30b is configured to search for the wire tail 51 at the operation location and grip the second part of the wire tail 51 at the second position at the operation location. It includes a second wire manipulating assembly 31b configured to releasably grip the second part of the wire tail 51 and a second actuator assembly 32b configured to move the second wire manipulating assembly 31b between the second position and its standby position.

Specifically, the second actuator assembly 32b, coupled to the second wire manipulating assembly 31b, is configured to move the second wire manipulating assembly 31b from its standby position to the second position to releasably grip the second part of the wire tail 51 after the wire tail 51 has been positioned at the operation location. It is further configured to move the second wire manipulating assembly 31b back to its standby position after the part of the wire tail 51 between the first and second wire manipulators 30a and 30b is straightened and the second wire manipulating assembly 31b releases the straightened part of the wire tail 51.

Referring to FIG. 4A, the second actuator assembly 32b may include a third actuator 321b configured to move the second wire manipulator 30b along a third motion rail 322b. The third motion rail 322b may be positioned at an acute angle relative to the wire threading direction. In other words, the third actuator 321b is operative to move the second wire manipulating assembly 31b along a slant direction relative to the Z-axis direction or vertical direction.

FIG.4B and FIG. 4C respectively show perspective and sectional views of the second wire manipulating assembly 31b according to one embodiment of the invention. Referring to FIG. 4B and 4C, the second wire manipulating assembly 31b includes a second manipulating mechanism 311b configured to releasably grip the second part of the wire tail 51. The second manipulating mechanism 311b may include two clamping elements and a motor configured to move at least one of the two clamping elements relative to the other, allowing it to releasably grip the second part of the wire tail 51.

The second wire manipulating assembly 31b may further include a second entry guide 312b, which is attached to or extends from the second manipulating mechanism 311b, to guide the wire tail 51 into position for gripping by the second manipulating mechanism 311b. Specifically, the second entry guide 312b may include two guide elements, respectively attached to or extending from the two clamping elements of the first manipulating mechanism, forming a funnel-like space to facilitate the entry of the bonding wire 50.

The second wire manipulating assembly 31b may further include a second pneumatic restraining mechanism 313b configured to generate airflow to restrain the second part of the wire tail 51. This second pneumatic restraining mechanism 313b includes a plurality of second airflow channels or vacuum slots 314b connected to an airflow generator (not shown). Additionally, the second pneumatic restraining mechanism 313b is further configured to adjust the position of the second part of the wire tail 51 using airflow so as to align it with a datum line D2.

The second wire manipulating assembly 31b may be further configured to restrain the wire tail 51 solely through the airflow generated by the second pneumatic restraining mechanism 313b. This configuration allows for precise adjustment of the length of the bonding wire 50, positioning the free end of the bonding wire 50 at a predetermined position by activating the wire spool 11.

The second wire manipulating assembly 31b may further include a cutting mechanism 315b configured to form a weakened portion on the second part of the wire tail 51 when it is gripped by the second wire manipulator 30b. As shown in FIG. 4C, the cutting mechanism 315b may take the form of a blade positioned near the clamping elements of the second manipulating mechanism 311b. This blade is configured to form a weakened portion, such as a stress concentration line, on the second part of the wire tail 51 when it is gripped by the second manipulating mechanism 311b to facilitate subsequent breaking or separation of the bonding wire 50. Consequently, when the first wire manipulator 30a moves along the wire threading direction to straighten the wire tail 51, the wire tail 51 breaks at the weakened portion, forming a straight and hard wire tip portion.

The wire manipulating device 30 may further include a vacuum suction mechanism for automatically receiving the removed wire. FIG. 4D shows a perspective view of the vacuum suction mechanism coupled to the second wire manipulator 30b to collect the part of the wire tail 51 removed from the bonding wire 50 according to one embodiment of the invention. The vacuum suction mechanism may include a suction nozzle 30e coupled to the second wire manipulator 30b to receive the removed part of the wire tail 51 and a pipe 30d connecting the suction nozzle 31e to the container 30c. The suction nozzle 30e is connected to the second wire manipulator 30b to receive the removed wire and convey it to the container 30c through the pipe 30d.

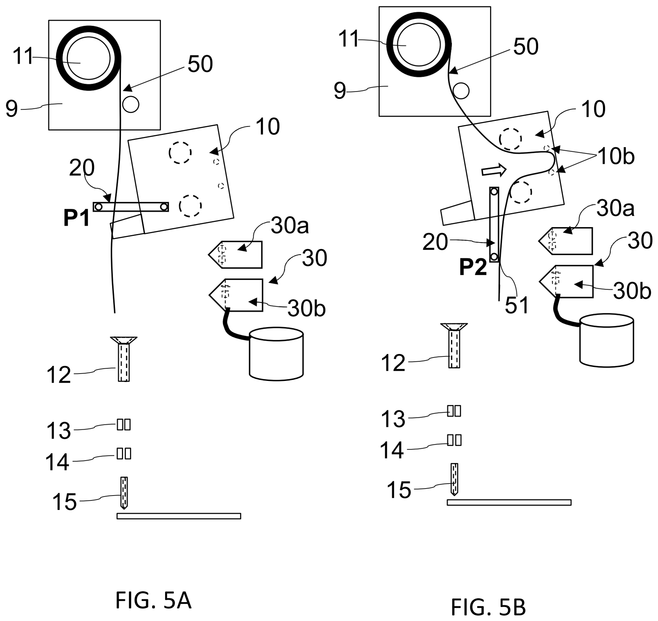

FIG. 5A to FIG. 5I illustrate the main steps performed by the wire threading system 100 when threading a bonding wire 50 through the wire bonding apparatus, according to some embodiments of the invention.

In FIG. 5A, a wire spool 11 with the bonding wire 50 wound around it is mounted on a wire spool holder 9, allowing a section of the bonding wire 50 to hang freely from the wire spool 11. The air path device 10 is located beneath the wire spool holder 9, while the wire guide device 20 is positioned at the first position P1, away from the operation location of the wire threading system 100. Meanwhile, the first and second wire manipulators 30a, 30b, of the wire manipulating device 30 are set to their standby positions.

In FIG. 5B, a length of the bonding wire 50 is sent into the air path device 10 by the wire feeding device and the air path device 10 generates an air flow to tension the bonding wire 50 and simultaneously the wire guide device 20 moves from the first position P1 to the second position P2 so as to guide the wire tail 51 of the bonding wire 50 to the operation location beneath the air path device 10. As the bonding wire 50 is tensioned by the airflow, it is confined or stopped within the air path device 10 by the wire stopper 10b. The wire feeding device may include a robotic arm or other types of wire feeding mechanism.

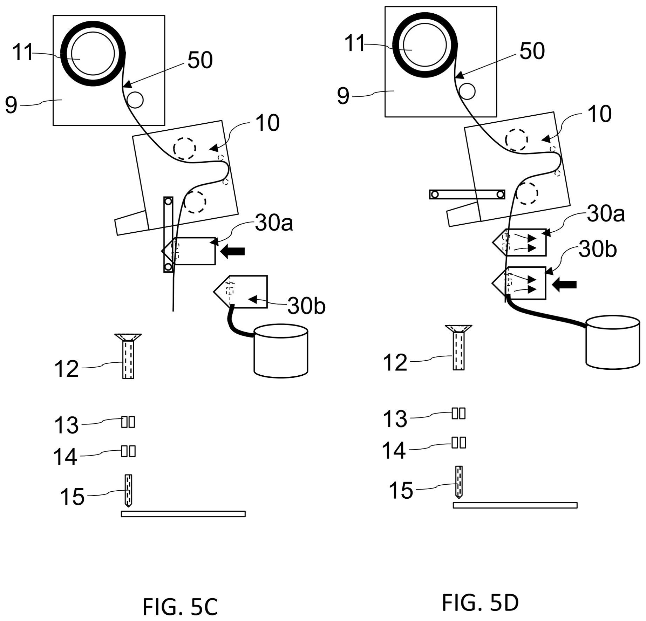

In FIG. 5C, the first wire manipulator 30a moves from its standby position to the operation location to search and find the wire tail 51, and grips the first part of the wire tail 51 at the first position at the operation location.

In FIG. 5D, the second wire manipulator 30b moves from its standby position to the operation location to search and find the wire tail 51, and grips the second part of the wire tail 51 at the second position at the operation location. Then, the first wire manipulator 30a generates a first airflow to securely restrain the first part of the wire tail 51 and align it with the datum line D1, the second wire manipulator 30b generates a second airflow to securely restrain the second part of the wire tail 51 and align it with the datum line D2, ensuring precise positioning. After the wire tail 51 is gripped by the first wire manipulator 30a, the wire guide device 20 may return to the first position P1.

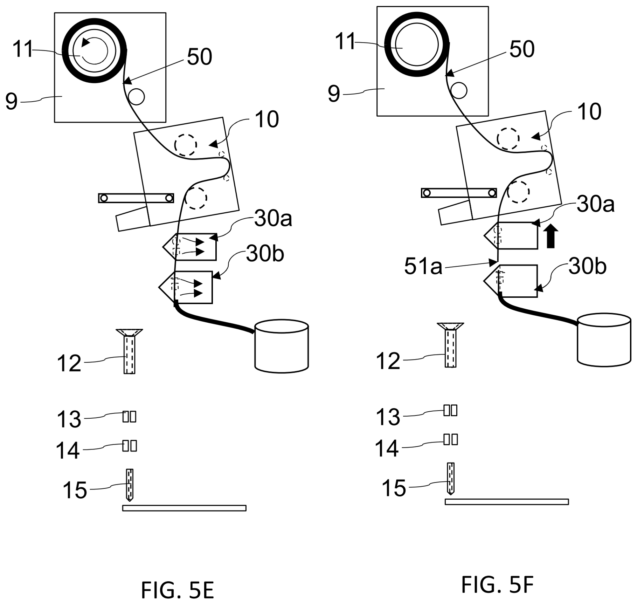

In FIG. 5E, the first and second wire manipulators 30a, 30b are operative to restrain the wire tail 51 solely using the first and second airflows. Then the position of the free end of the bonding wire 50 is adjusted by activating the wire spool 11 so that the free end of the bonding wire 50 is positioned precisely at a predetermined location relative to the second wire manipulator 30b. As shown in FIG. 5E, the free end is positioned near the bottom end of the second wire manipulator 30b.

In FIG.5F, the second wire manipulator 30b grips the wire tail 51 and forms a weakened portion on the second part by creating a stress concentration thereon with the cutting mechanism 315b, which may include a blade. The first wire manipulator 30a grips the wire tail 51 and moves up and away from the second wire manipulator 30b, so as to straighten the part of the wire tail 51 between the first and second wire manipulators 30a, 30b, so as to break the wire tail 51 at the weakened portion to form a straight wire tip portion 51a. The formation of the wire tip portion 51a can facilitate the subsequent threading process.

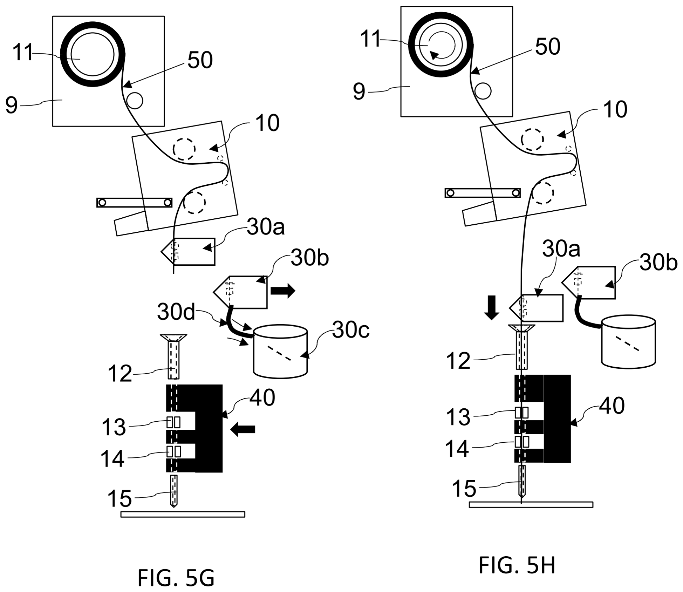

In FIG. 5G, the second wire manipulator 30b holds the removed wire, returns to its standby position and transfers the removed wire to the container 30c through the pipe 30d. At the same time, the wire threading device 40 moves to its operation position between the air tensioner 12 and the bonding tool 15 of the wire bonding apparatus and is aligned with them.

In FIG. 5H, the first wire manipulator 30a moves along the wire threading direction to convey the straightened wire tail 51 from the operation location to the threading location above the air tensioner 12. Once in position, the air tensioner 12 and the wire threading device 40 are activated to receive and thread the wire tail 51 through the bonding tool 15, ensuring proper alignment and effective threading.

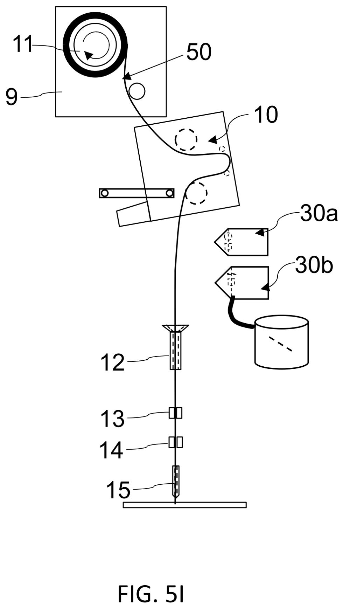

In FIG. 5I, after the wire tail 51 has been successfully threaded through the bonding tool 15, the first wire manipulator 30a and the wire threading device 40 return to their respective standby positions.

As described above, embodiments of the invention provide a wire threading system and method for automatically threading a bonding wire through the bonding tool of the wire bonding apparatus. With the proposed method and system, the bonding wire is sent into an air path device, tensioned by an airflow generated therein and confined within the air path device by the wire stopper arranged in the air path device. Simultaneously the wire tail of the bonding wire is guided to the operation location beneath the air path device by the wire guide device movably coupled to the air path device. The wire manipulating device moves to the operation location to search, locate, grip, straighten and convey the wire tail to the threading location for a subsequent threading process. Thus, the accuracy and efficiency of the wire threading process can be significantly improved.

The wire manipulating device includes two wire manipulators integrated with an airflow generation mechanism that aids in searching for, locating, and securely restraining and gripping the bonding wire at the operation location. Additionally, the airflow generation mechanism allows adjustment of the position of the free end of the bonding wire to enhance the accuracy of the positioning of the bonding wire. It also enables the programmable and controllable application of a gripping force by the wire manipulators on the bonding wire, thereby ensuring the wire tail is straightened before it is broken to effectively form a wire tip portion.

Although the present invention has been described in considerable detail with reference to certain embodiments, other embodiments are possible. For example, the air path device can have various shapes and structures, and the wire guide device may be designed as a guide element with different shapes and configurations. Similarly, the wire manipulators can be arranged in different ways, including variations in the actuators used to control them. Therefore, the spirit and scope of the appended claims should not be limited to the description of the embodiments contained herein.

## Claims

1. A wire threading method for automatically threading a bonding wire in a wire bonding apparatus, the method comprising the steps of:
feeding a length of the bonding wire from a wire spool into an air path device;
tensioning the bonding wire with an airflow generated in the air path device and simultaneously guiding a wire tail of the bonding wire to an operation location with a wire guide device;
gripping and straightening the wire tail at the operation location with a wire manipulating device;
conveying the straightened wire tail to a threading location with the wire manipulating device; and
threading the straightened wire tail with a wire threading device through a bonding tool of the wire bonding apparatus.

2. The method according to claim 1, wherein the step of feeding the length of the bonding wire into the air path device comprises: conveying the length of the bonding wire into the air path device with a robotic arm or a movable wire feeding mechanism.

3. The method according to claim 1, wherein the step of guiding the wire tail comprises: guiding the wire tail to the operation location with the wire guide device which is movable between a first position remote from the operation location and a second position adjacent to the operation position, the wire tail being guided to the operation location as the wire guide device moves from the first position to the second position.

4. The method according to claim 3, wherein the wire guide device includes a pivotable guide element coupled to the air path device, the guide element having a first end rotatably coupled to a pivot installed on the air path device and a second end movable between the first position and the second position.

5. The method according to claim 1, further comprising: removing a part of the wire tail with the wire manipulating device to form a wire tip portion before conveying the straightened wire tail to the threading location for threading.

6. The method according to claim 5, further comprising: forming a weakened portion on the wire tail with the wire manipulating device before removing the part of the wire tail.

7. The method according to claim 6, wherein the step of removing the part of the wire tail is performed at the same time as the wire manipulating device is straightening the wire tail.

8. The method according to claim 1, wherein the air path device comprises an airflow generator for generating the airflow to tension the bonding wire in the air path device and a wire stopper configured to confine the bonding wire within the air path device.

9. The method according to claim 8, wherein the wire stopper has a mesh structure.

10. The method according to claim 1, wherein the wire manipulating device comprises first and second movable wire manipulators, and the step of gripping the wire tail comprises: gripping a first part of the wire tail with the first wire manipulator at a first position at the operation location and gripping a second part of the wire tail with the second wire manipulator at a second position at the operation location, the first position being closer to the air path device than the second position.

11. The method according to claim 10, further comprising: restraining the wire tail with an airflow generated within the first and second wire manipulators so as to locate a free end of the bonding wire at a predetermined position relative to the second wire manipulator by activating the wire spool.

12. The method according to claim 10, further comprising: forming a weakened portion on the second part of the wire tail with the second wire manipulator.

13. The method according to claim 12, wherein the second wire manipulator includes a cutting mechanism configured to apply force to a point on the second part of the wire tail to form the weakened portion while the second part of the wire tail is gripped by the second wire manipulator.

14. The method according to claim 12, wherein the step of straightening the wire tail further comprises: moving the first wire manipulator away from the second wire manipulator to straighten the wire tail and break the wire tail at the weakened portion simultaneously so that a part of the wire tail is removed from the bonding wire and gripped by the second wire manipulator.

15. The method according to claim 14, further comprising: automatically transferring the part of the wire tail removed from the bonding wire to a container with a vacuum suction mechanism, wherein the vacuum suction mechanism includes a suction nozzle coupled to the second wire manipulator for receiving the removed part of the wire tail and a pipe connecting the suction nozzle to the container for transferring the removed part of the wire tail to the container.

16. A wire threading system for automatically threading a bonding wire in a wire bonding apparatus, the system comprising a wire feeding device, an air path device, a wire guide device, a wire manipulating device and a wire threading device, wherein
the wire feeding device is configured to feed a length of the bonding wire from a wire spool into the air path device;
the air path device is configured to tension the bonding wire with an airflow;
the wire guide device is configured to guide a wire tail of the bonding wire to an operation position when the air path device applies tension to the bonding wire;
the wire manipulating device is configured to grip and straighten the wire tail at the operation location, and convey the straightened wire tail to a threading location; and
the wire threading device configured to receive the straightened wire tail and to thread the straightened wire tail though a bonding tool of the wire bonding apparatus.

17. The wire threading system according to claim 16, wherein the wire guide device is coupled to the air path device and includes a pivotable guide element having a first end rotatably coupled to a pivot installed on the air path device and a second end movable between a first position remote from the operation location and a second position adjacent to the operation location.

18. The wire threading system according to claim 16, wherein the wire manipulating device comprises first and second wire manipulators, wherein the first wire manipulator is configured to releasably grip a first part of the wire at a first position at the operation location and the second wire manipulator is configured to releasably grip a second part of the wire with the second wire manipulator at a second position at the operation location, the first position being closer to the air path device than the second position.

19. The wire threading system according to claim 18, wherein the first and second wire manipulators are configured to restrain the bonding wire with an airflow generated within them to allow a free end of the bonding wire to be positioned at a predetermined position relative to the second wire manipulator by activating the wire spool.

20. The wire threading system according to claim 18, wherein the first wire manipulator is configured to move upward relative to the second wire manipulator to straighten the part of the wire tail between the first and second wire manipulators and to remove a part of the wire tail from the bonding wire to form a wire tip portion.

21. The wire threading system according to claim 18, wherein the second wire manipulator includes a cutting mechanism configured to apply a force to a point on the second part of the wire tail to form a weakened portion on the wire tail when the wire tail is gripped by the second wire manipulator.

22. The wire threading system according to claim 16, wherein the air path device includes an airflow generator configured to generate the airflow for tensioning the bonding wire and a wire stopper configured to confine the bonding wire within the air path device.

23. The wire threading system according to claim 18, wherein the wire manipulating device further comprises a vacuum suction mechanism including a suction nozzle coupled to the second wire manipulator for receiving a part of the wire tail removed from the bonding wire and a pipe connecting the suction nozzle to a container for automatically transferring the removed part of the wire tail into the container.

24. The wire threading system according to claim 16, wherein the wire feeding device includes a wire inlet guide fixedly attached to the air path device.
